(19) Europäisches Patentamt
European Patent Office
Office européen des brevets

(11) EP 2 242 178 A1

(12) EUROPEAN PATENT APPLICATION

(43) Date of publication:
20.10.2010 Bulletin 2010/42

(51) Int Cl.:
H03K 5/13 (2006.01)

(21) Application number: 09290277.4

(22) Date of filing: 15.04.2009

(84) Designated Contracting States:
AT BE BG CH CY CZ DE DK EE ES FI FR GB GR
HR HU IE IS IT LI LT LU LV MC MK MT NL NO PL
PT RO SE SI SK TR
Designated Extension States:
AL BA RS

(71) Applicant: NXP B.V.
5656 AG Eindhoven (NL)

(72) Inventors:
• Amiot, Sébastien
  14079 Caen (FR)
• Tourret, Jean-Robert
  14906 Caen (FR)

(74) Representative: Schouten, Marcus Maria et al
NXP B.V.
IP & L Department
High Tech Campus 32
5656 AE Eindhoven (NL)

(54) **Digital phase shifting for imparting a target delay on an input signal to generate an output signal**

(57) A technique for imparting a target delay on an input signal to generate an output signal involves incrementally changing the number of coarse delay cell circuits that are enabled until the difference between the target delay and the coarse delay that is imparted by the enabled coarse delay cell circuits is smaller than a fixed period of delay that is imparted by a single coarse delay cell circuit. The coarse delay that is imparted by the enabled coarse delay cell circuits is a function of the number of coarse delay cell circuits that are enabled. Additionally, a fine delay cell circuit is adjusted until the delay imparted on the input signal is equal to the difference between the target delay and the coarse delay that is imparted by the enabled coarse delay cell circuits. The output of the fine delay cell circuit is the output signal.

FIG. 1

EP 2 242 178 A1

**Description**

SUMMARY AND BACKGROUND OF THE INVENTION

Embodiments of the invention relate generally to signal processing systems and methods and, more particularly, to digital phase shifting for imparting a target delay on an input signal to generate an output signal.

A concern with wide band radio frequency transceivers is that wide shifting capabilities of analog delay lock loops result in high feedback loop gains, which can lead to poor noise performance and reciprocal mixing issues. Thus, there is a need for a system and method for digital phase shifting that reduces the high feedback loop gains.

A digital phase shifting method for imparting a target delay on an input signal to generate an output signal involves incrementally changing the number of coarse delay cell circuits that are enabled until the difference between the target delay and the coarse delay that is imparted by the enabled coarse delay cell circuits is smaller than a fixed period of delay that is imparted by a single coarse delay cell circuit. The coarse delay that is imparted by the enabled coarse delay cell circuits is a function of the number of coarse delay cell circuits that are enabled. Additionally, a fine delay cell circuit is adjusted until the delay imparted on the input signal by the fine delay cell circuit is equal to the difference between the target delay and the coarse delay that is imparted by the enabled coarse delay cell circuits. The output of the fine delay cell circuit is the output signal

In an embodiment, a digital phase shifting method for imparting a target delay on an input signal to generate an output signal includes incrementally changing the number of coarse delay cell circuits that are enabled until the difference between the target delay and the coarse delay that is imparted by the enabled coarse delay cell circuits is smaller than a fixed period of delay that is imparted by a single coarse delay cell circuit, where the coarse delay that is imparted by the enabled coarse delay cell circuits is a function of the number of coarse delay cell circuits that are enabled, and adjusting a fine delay cell circuit until the delay imparted on the input signal by the fine delay cell circuit is equal to the difference between the target delay and the coarse delay that is imparted by the enabled coarse delay cell circuits, where the output of the fine delay cell circuit is the output signal.

In an embodiment, a digital phase shifter for imparting a target delay on an input signal to generate an output signal includes multiple serially connected coarse delay cell circuits, a fine delay cell, and a delay adjuster. Each coarse delay cell circuit is configured to impart a fixed period of delay on the input signal, and wherein the coarse delay imparted by the serially connected coarse delay cell circuits is a function of the number of coarse delay cell circuits that are enabled. The fine delay cell circuit is configured to impart a delay on the input signal to generate the output signal, where the delay is smaller than the fixed period of delay that is imparted by a single coarse delay cell circuit. The delay adjuster is configured to incrementally change the number of coarse delay cell circuits that are enabled until the difference between the target delay and the coarse delay is smaller than the fixed period of delay that is imparted by a single coarse delay cell circuit and to adjust the fine delay cell circuit until the delay imparted by the fine delay cell circuit is equal to the difference between the target delay and the coarse delay that is imparted by the enabled coarse delay cell circuits.

In another embodiment, a digital phase shifting method for imparting a target delay on an input signal to generate an output signal includes operating in a calibration mode and operating in a continuous operation mode. Operating in the calibration mode includes determining a phase difference between the input signal and the output signal to generate a phase differential signal, updating a counter value in response to the phase differential signal, and incrementally changing the number of coarse delay cell circuits that are enabled in response to the counter value until the difference between the target delay and the coarse delay that is imparted by the enabled coarse delay cell circuits is smaller than a fixed period of delay that is imparted by a single coarse delay cell circuit, where the coarse delay that is imparted by the enabled coarse delay cell circuits is a function of the number of coarse delay cell circuits that are enabled. Once the difference between the target delay and the coarse delay that is imparted by the enabled coarse delay cell circuits is smaller than a fixed period of delay that is imparted by a single coarse delay cell circuit, operating in the continuous operation mode starts. Operating in the continuous operation mode includes adjusting a fine delay cell circuit according to the phase differential signal until the delay imparted by the fine delay cell circuit on the input signal is equal to the difference between the target delay and the coarse delay that is imparted by the enabled coarse delay cell circuits, where the output of the fine delay cell circuit is the output signal.

Other aspects and advantages of embodiments of the present invention will become apparent from the following detailed description, taken in conjunction with the accompanying drawings, depicted by way of example of the principles of the invention.

DESCRIPTION OF THE DRAWINGS

Fig. 1 depicts a digital phase shifter for imparting a target delay on an input signal to generate an output signal in accordance with an embodiment of the invention.

Fig. 2 depicts an embodiment of the fine delay cell circuit of Fig. 1.

Fig. 3 illustrates an operation chronogram of the digital phase shifter of Fig. 1.

Fig. 4 depicts a digital phase shifter for imparting a target delay on an input signal to generate an output signal that utilizes digital tuning of a fine delay cell circuit in accordance with an embodiment of the invention.

Fig. 5 depicts an embodiment of the fine delay cell circuit of Fig. 4.

Fig. 6 is a process flow diagram of a digital phase shifting method for imparting a target delay on an input signal to generate an output signal in accordance with an embodiment of the invention.

Throughout the description, similar reference numbers may be used to identify similar elements.

DETAILED DESCRIPTION OF THE EMBODIMENTS

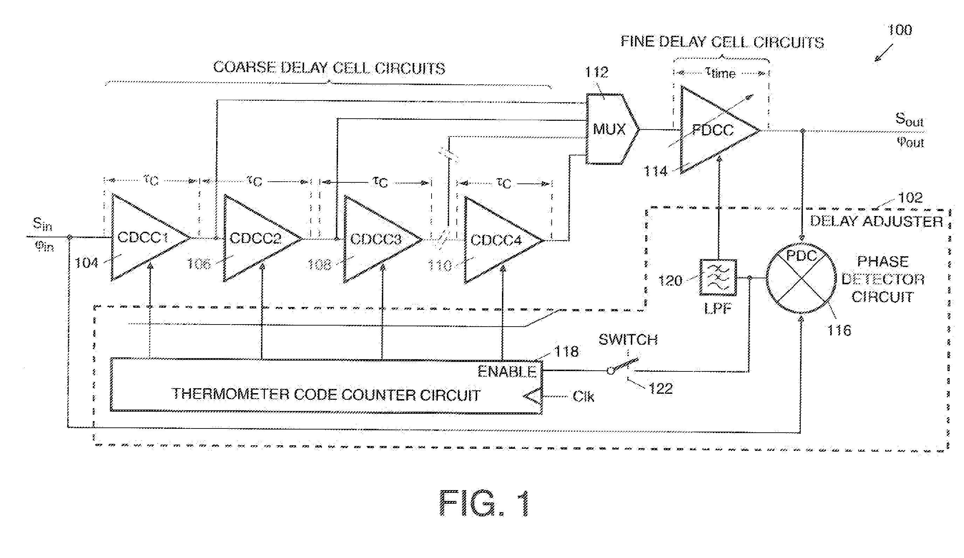

Fig. 1 depicts a digital phase shifter 100 for imparting a target delay on an input signal to generate an output signal in accordance with an embodiment of the invention. As shown in Fig. 1, the digital phase shifter includes a delay adjuster 102, at least four serially connected coarse delay cell circuits (CDCCs) CDCC1 104, CDCC2 106, CDCC3 108, and CDCC4 110, a multiplexer (MU'X) 112, and a fine delay cell circuit (FDCC) 114.

In the embodiment of Fig. 1, the delay adjuster 102 includes a phase detector circuit (PDC) 116, a thermometer code counter circuit (TCCC) 118, a low pass filter circuit (LPF) 120, and a switch 122. The delay adjuster is configured to either incrementally decrease or incrementally increase the number of coarse delay cell circuits that are enabled until the difference between the target delay and the coarse delay is smaller than the fixed period of delay that is imparted by a single coarse delay cell circuit and to adjust the fine delay cell circuit 114 until the delay imparted by the fine delay cell circuit is equal to the difference between the target delay and the coarse delay that is imparted by the enabled coarse delay cell circuits.

The phase detector circuit 116 is configured to compare the phase, $\varphi_{in,}$ of an input signal, $S_{in,}$ to the phase, $\varphi_{out,}$ of an output signal, $S_{out,}$ and to provide a phase differential signal to the low pass filter 120 and the thermometer code counter circuit 118. The phase differential signal may be a phase error control voltage, $V_{cmp}$, which can be expressed as:

$$V_{cmp} = A_v \times \left( \left( \varphi_{in} - \varphi_{out} \right) - \varphi_{ref} \right), \ V_{cmp} \in [0, \text{Vdd}] \qquad (1)$$

where $A_v$ is a gain of the phase detector circuit, $\varphi_{ref}$ is a target phase difference, and where zero or ground (GND) is the lower limit of the phase error control voltage, $V_{cmp}$, and Vdd is the upper limit of the phase error control voltage, $V_{cmp}$. The target phase difference, $\varphi_{ref}$, corresponds to the target delay. When the gain of the phase detector circuit, $A_v$, has a relatively high value and the phase difference, $\varphi_{in}$-$\varphi_{out,}$ between the input signal, $S_{in}$, and the output signal, $S_{out.,}$ is far from the target phase difference, $\varphi_{ref}$, the phase error control voltage, $V_{cmp}$, is zero or Vdd.

The thermometer code counter circuit 118 is configured to update a counter value "TCC_count" in response to the phase error control voltage, $V_{cmp}$. In the embodiment of Fig. 1, the phase error control voltage, $V_{cmp}$, is sampled on a rising edge of a sampling clock, Clk. When the phase error control voltage, $V_{cmp}$, is Vdd, the counter value is increased and when the phase error control voltage, $V_{cmp}$, is zero or ground, the counter value is decreased.

The low pass filter circuit 120 is configured to filter the phase error control voltage, $V_{cmp}$, and to output a filtered phase error control voltage, $V_{cmp\_filt}$, to the fine delay cell circuit 114. The filtered phase error control voltage, $V_{cmp\_filt,}$ produced by the low pass filter circuit is stable, nearly continuous, and at least free from any high frequency components.

The switch 122 is configured to connect the thermometer code counter circuit 118 with the phase detector circuit 116. When the switch is configured to be on, the phase detector circuit is connected to the thermometer code counter circuit and when the switch is configured to be off, the phase detector circuit is not connected to the thermometer code counter circuit. In the embodiment of Fig. 1, the switch is controlled by a switch control signal CAL_EN, where the switch is on when the switch control signal CAL_EN is "1" and off when the switch control signal CAL_EN is "0."

The coarse delay cell circuits CDCC1 104, CDCC2 106, CDCC3 108, and CDCC4 110 are serially connected to each other and each coarse delay cell circuit is configured to delay the input signal a fixed period of time. In the embodiment of Fig. 1, each coarse delay cell circuit is configured to delay the input signal the same fixed period of time. The magnitude of the coarse delay that is imparted by the serially connected coarse delay cell circuits is a function of the number of coarse delay cell circuits that are enabled. In the embodiment of Fig. 1, when a bit of the counter value is set to "1," the corresponding coarse delay cell circuit is disabled and does not impart delay on the input signal, and when a bit of the counter value is set to "0," the corresponding coarse delay cell circuit is enabled and imparts a fixed period of delay time, $\tau_c$, on the input signal. In some embodiments, there may be no coarse delay cell circuit enabled. In some embodiments, there may be only one coarse delay cell circuit enabled and in other embodiments, there may be multiple coarse delay cell circuits enabled. Although four coarse delay cell circuits are shown, the number of coarse delay cell circuits can be more or less than four.

The multiplexer 112 is connected to an output of each of the coarse delay cell circuits CDCC1 104, CDCC2 106, CDCC3 108, and CDCC4 110 and an input of the fine delay cell circuit 114. The multiplexer multiplexes the signals from the series of coarse delay cell circuits into a coarse delay signal that is provided to the fine delay cell circuit.

The fine delay cell circuit 114 is configured to impart a delay on the input signal to generate the output signal. In the embodiment of Fig. 1, the delay imparted by the fine delay cell circuit is smaller than the fixed period of delay that is imparted by a single coarse delay cell circuit. In the embodiment of Fig. 1, the fine delay cell circuit is configured to delay the input signal a time, $\tau_{fine}$, which is proportional to the filtered phase error control voltage, $V_{cmp\_filt}$. The delay time of the input signal, $\tau_{fine}$, can be expressed as:

$$\tau_{fine} = \tau_c \times \frac{V_{cmp\_filt}}{Vdd} \tag{2}$$

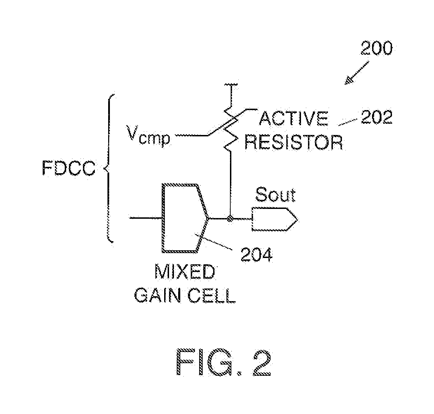

The fine delay cell circuit may be a voltage controlled resistor, an R-2R resistor ladder network, or any other apparatus that can delay the input signal within a well controlled time interval. Fig. 2 depicts an embodiment of the fine delay cell circuit 114 of Fig. 1. As shown in Fig. 2, the fine delay cell circuit 200 includes an active resistor 202 and a mixed gain cell 204. In the embodiment of Fig. 2, the active resistor is configured to be controlled by the phase error control voltage, $V_{cmp}$. The mixed gain cell receives an input voltage and outputs an output current proportional to the input voltage. The ratio between the amplitude of the output current and the amplitude of the input voltage is called mixed gain (gm) of the mixed gain cell.

The digital phase shifter 100 depicted in Fig. 1 is configured to operate in a calibration mode or in a continuous operation mode. In an embodiment, the digital phase shifter operates in the calibration mode until the coarse delay is adjusted to within a certain tolerance and then the digital phase shifter switches to the continuous operation mode.

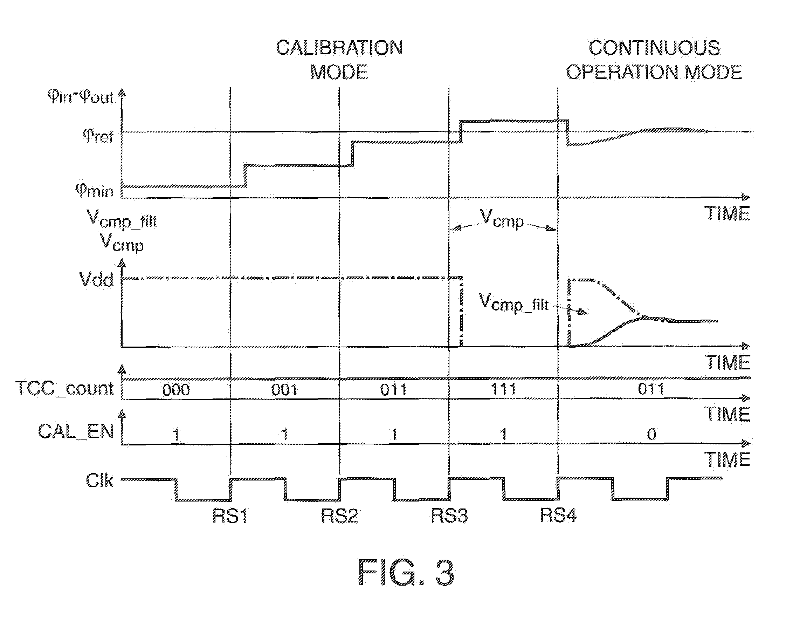

Fig. 3 illustrates an operation chronogram of the digital phase shifter of Fig. 1. As shown in Fig. 3, at the start of the calibration mode, the switch control signal CAL_EN is "1." As a result, the switch 122 is on and the phase detector circuit 116 is connected to the thermometer code counter circuit 118. Additionally, the counter value "TCC_count" of the thermometer code counter circuit is "000" and the phase difference, $\varphi_{in}$-$\varphi_{out}$, between the input signal, $S_{in}$, and the output signal, $S_{out}$, is at a minimum, $\varphi_{min}$, which is far from the target phase difference, $\varphi_{ref}$. Furthermore, the delay between the input signal, $S_{in}$, and the output signal, $S_{out}$, is at a minimum and the phase error control voltage, $V_{cmp}$, is equal to the upper limit, Vdd. Once the calibration mode starts, the thermometer code counter circuit updates the counter value on each rising edge of the sampling clock, Clk, in response to the phrase error control voltage, $V_{cmp}$. On the rising edge "RS1" of the sampling clock, Clk, the counter value is increased to "001," which causes a coarse delay cell circuit to be enabled, which in turn causes the phase difference, $\varphi_{in}$-$\varphi_{out}$, to move closer to the target phase difference, $\varphi_{ref}$.

The increases in the counter value, and the corresponding increases in the coarse delay, continue until the phase difference, $\varphi_{in}$-$\varphi_{out}$, exceeds the target phase difference, $\varphi_{ref}$. Once the phase difference, $\varphi_{in}$-$\varphi_{out}$, exceeds the target phase difference, $\varphi_{ref}$, the thermometer code counter circuit then decreases the counter value "TCC_count" to "011" on the rising edge "RS4" and the number of the coarse delay cell circuits that are enabled, Nc, is determined. In an embodiment, each coarse delay cell circuit is configured to delay the input signal the same fixed period of time and the total coarse delay that is imparted by the serially connected coarse delay cell circuits, $\tau_{cs}$, is proportional to the number of coarse delay cell circuits that are enabled, Nc. The relationship between the coarse delay, $\tau_{cs}$, the number of the coarse delay cell circuits that are enabled, Nc, and the fixed period of delay time that is imparted by a single coarse delay cell circuit, $\tau_c$, can be expressed as:

$$\tau_{cs} = N_c \times \tau_c \tag{3}$$

Once the number of the coarse delay cell circuits that are enabled, Nc, is determined, the difference between a target delay, $\tau_w$, and the coarse delay, that is imparted by the enabled coarse delay cell circuits, $\tau_{cs}$, will be smaller than the fixed period of delay that is imparted by a single coarse delay cell circuit. The relationship between the target delay, $\tau_w$, the coarse delay, $\tau_{cs}$, and the fixed period of delay time that is imparted by a single coarse delay cell circuit,

$\tau_{C,}$ can be expressed as:

$$\left(\tau_w - \tau_{cs}\right) < \tau_c \tag{4}$$

Once Nc is determined, the switch control signal CAL_EN goes to "0." As a result, the switch is turned off, the phase detector circuit output is no longer provided to the thermometer code counter circuit, the sampling clock, Clk, is no longer provided to the thermometer code counter circuit, and the continuous operation mode starts. In the calibration mode, the low pass filter circuit 120 is not used.

In the continuous operation mode, also referred to as the fine tuning mode, the fine delay cell circuit 114 is adjusted until the delay imparted on the input signal by the fine delay cell circuit is equal to the difference between the target delay and the coarse delay that is imparted by the enabled coarse delay cell circuits. Additionally, in the continuous operation mode, the phase detector circuit 116, the coarse delay cell circuits, the multiplexer 112, and the fine delay cell circuit form a feedback loop and the low pass filter circuit 120 controls the bandwidth of the feedback loop and stabilizes the feedback loop. In some embodiments, for example, in Television receivers, the calibration mode is not allowed immediately after power-up. In this case, the fine delay cell circuit is set to delay the input signal coping with temperature variations.

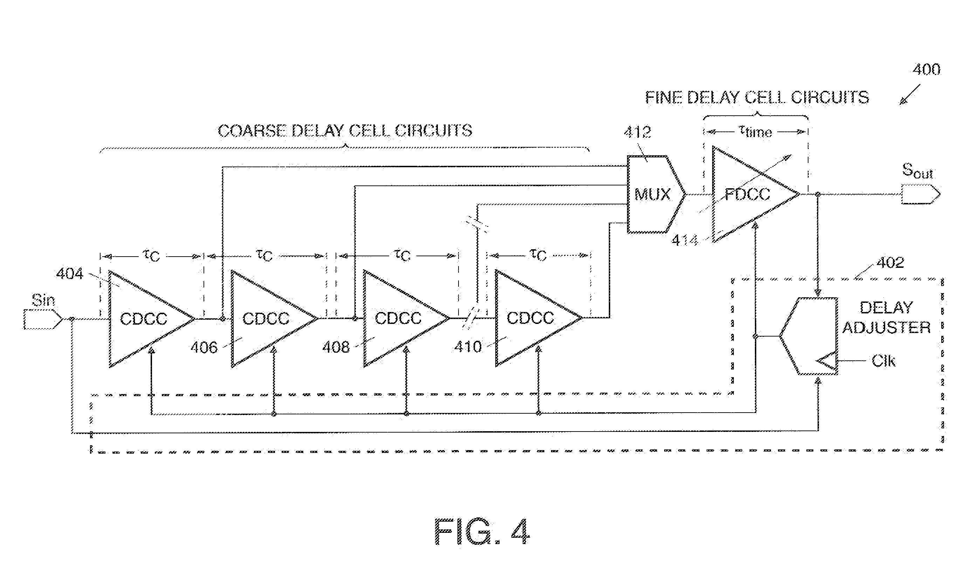

Fig. 1 depicts a digital phase shifter 100 that utilizes analog tuning of the fine delay cell circuit 114. However, digital tuning of the fine delay cell circuit is possible depending on the minimum quantized delay error. Fig. 4 depicts a digital phase shifter 400 for imparting a target delay on an input signal to generate an output signal that utilizes digital tuning of a fine delay cell circuit in accordance with an embodiment of the invention. As shown in Fig. 4, the digital phase shifter includes a delay adjuster 402, at least four coarse delay cell circuits 404, 406, 408, and 410, a multiplexer 412, and a fine delay cell circuit 414.

In the embodiment of Fig. 4, the delay adjuster 402 is configured to determine a phase difference between the input signal and the output signal to generate a digital phase differential signal and to sample the digital phase differential signal on a rising edge of a sampling clock, Clk, to generate a sampling result. The delay adjuster is also configured to update a counter value in response to the sampling result and to incrementally increase or decrease the number of coarse delay cell circuits that are enabled in response to the counter value until the difference between the target delay and the coarse delay that is imparted by the enabled coarse delay cell circuits is smaller than a fixed period of delay that is imparted by a single coarse delay cell circuit, where the coarse delay that is imparted by the enabled coarse delay cell circuits is a function of the number of coarse delay cell circuits that are enabled. The delay adjuster is further configured to adjust the fine delay cell circuit 414 until the delay imparted by the fine delay cell circuit is equal to the difference between the target delay and the coarse delay that is imparted by the enabled coarse delay cell circuits. In some embodiments, the delay adjuster is further configured to compare the phase difference between the input signal and the output signal with a target phase difference to generate the digital phase differential signal, where the target phase difference corresponds to the target delay, The delay adjuster may be a phase-to-digital converter, an accumulator, or any digital circuitry that performs phase converting. The counter coding type used by the delay adjuster is dependent on how the delay cell circuits are connected. In some embodiments, the counter coding type is thermometer code.

The coarse delay cell circuits 404, 406, 408, and 410 are serially connected to each other and each coarse delay cell circuit is configured to delay the input signal a fixed period of time. The magnitude of the coarse delay that is imparted by the serially connected coarse delay cell circuits is a function of the number of coarse delay cell circuits that are enabled. In the embodiment of Fig. 4, when a bit of the counter value is set to "1," the corresponding coarse delay cell circuit is disabled and does not impart delay on the input signal, and when a bit of the counter value is set to "0," the corresponding coarse delay cell circuit is enabled and imparts a fixed period of delay time on the input signal. In some embodiments, there may be no coarse delay cell circuit enabled. In some embodiments, there may be only one coarse delay cell circuit enabled, In some embodiments, there may be multiple coarse delay cell circuits enabled.

The multiplexer 412 is connected to an output of each of the coarse delay cell circuits 404, 406, 408, and 410 and to an input of the fine delay cell circuit 414. The multiplexer multiplexes the signals from the series of coarse delay cell circuits into a coarse delay signal that is provided to the fine delay cell circuit.

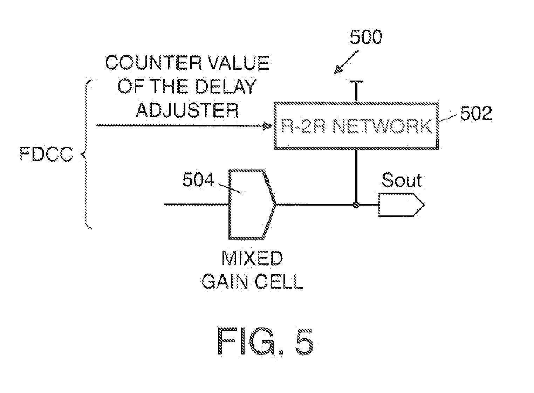

The fine delay cell circuit 414 is configured to impart a delay on the input signal to generate the output signal, where the delay is smaller than the fixed period of delay that is imparted by a single coarse delay cell circuit. In the embodiment of Fig. 4, the fine delay cell circuit is configured to delay the input signal a time that is proportional to the digital phase differential signal that is received from the delay adjuster 402. The fine delay cell circuit may be a voltage controlled resistor, an R-2R resistor ladder network, or any other apparatus that can delay the input signal within a well controlled time interval. Fig. 5 depicts an embodiment of the fine delay cell circuit 414 of Fig. 4. As shown in Fig. 5, the fine delay cell circuit 500 includes an R-2R resistor ladder network 502 and a mixed gain cell 504. In the embodiment of Fig. 5, the R-2R resistor ladder network is configured to be controlled by the counter value of the delay adjuster 402. The mixed gain cell receives an input voltage and outputs an output current proportional to the input voltage. The ratio between the amplitude of the output current and the amplitude of the input voltage is called mixed gain (gm) of the mixed gain cell.

The digital phase shifter 400 is configured to operate in a calibration mode or in a continuous operation mode. In the calibration mode, the delay adjuster 402 incrementally changes the number of coarse delay cell circuits that are enabled until the difference between the target delay and the coarse delay imparted by the serially connected coarse delay cell circuits is smaller than the fixed period of delay that is imparted by a single coarse delay cell circuit. Once the difference between the target delay and the coarse-delay imparted by the serially connected coarse delay cell circuits is smaller than the fixed period of delay that is imparted by a single coarse delay cell circuit, the continuous operation mode starts. In the continuous operation mode, the delay adjuster adjusts the fine delay cell circuit 412 until the delay imparted by the fine delay cell circuit is equal to the difference between the target delay and the coarse delay that is imparted by the enabled coarse delay cell. In particular, the delay adjuster, the coarse delay cell circuits, the multiplexer 412, and the fine delay cell circuit form a feedback loop and the delay adjuster stabilizes the feedback loop.

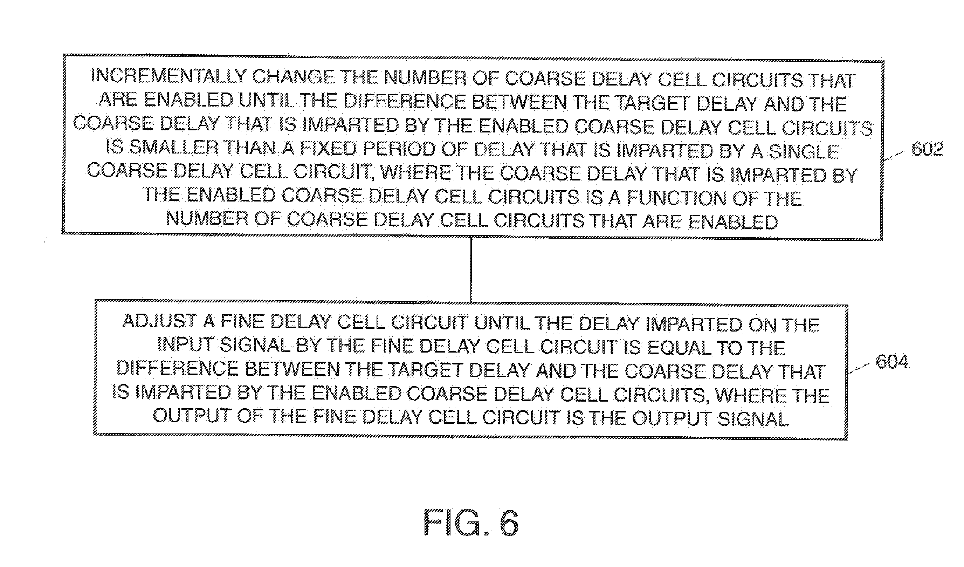

Fig. 6 is a process flow diagram of a digital phase shifting method for imparting a target delay on an input signal to generate an output signal in accordance with an embodiment of the invention. At block 602, the number of coarse delay cell circuits that are enabled is incrementally changed until the difference between the target delay and the coarse delay that is imparted by the enabled coarse delay cell circuits is smaller than a fixed period of delay that is imparted by a single coarse delay cell circuit, where the coarse delay that is imparted by the enabled coarse delay cell circuits is a function of the number of coarse delay cell circuits that are enabled. At block 604, a fine delay cell circuit is adjusted until the delay imparted on the input signal by the fine delay cell circuit is equal to the difference between the target delay and the coarse delay that is imparted by the enabled coarse delay cell circuits, where the output of the fine delay cell circuit is the output signal.

Embodiments of the invention can be applied to radio frequency transceivers, transmitters, and receivers, which require multiple quadrature or sub-quadrature phases. For example, embodiments of the invention can be applied to harmonic reject mixer architectures in broadband receivers, such as Television (TV) receivers and Ultra Wide Band (UWB) receivers. Embodiments of the invention can also be applied to homodyne Zero Intermediate Frequency (IF) or Low IF transceiver architectures, such as Global System for Mobile communication (GSM) transceivers, Universal Mobile Telecommunications System (UMTS) transceivers, and Wireless Local Area Network (WLAN) transceivers. Embodiments of the invention can be also applied to TV tuners for portable and mobile TV applications.

Although the operations of the method herein are shown and described in a particular order, the order of the operations of the method may be altered so that certain operations may be performed in an inverse order or so that certain operations may be performed, at least in part, concurrently with other operations. In another embodiment, instructions or sub-operations of distinct operations may be implemented in an intermittent and/or alternating manner.

Although specific embodiments of the invention that have been described or depicted include several components described or illustrated herein, other embodiments of the invention may include fewer or more components to implement less or more functionality.

Although specific embodiments of the invention have been described and illustrated, the invention is not to be limited to the specific forms or arrangements of parts so described and illustrated. The scope of the invention is to be defined by the claims appended hereto and their equivalents.

**Claims**

1. A digital phase shifting method for imparting a target delay on an input signal to generate an output signal, the digital phase shifting method comprising:

   - incrementally changing the number of coarse delay cell circuits that are enabled until the difference between the target delay and the coarse delay that is imparted by the enabled coarse delay cell circuits is smaller than a fixed period of delay that is imparted by a single coarse delay cell circuit, wherein the coarse delay that is imparted by the enabled coarse delay cell circuits is a function of the number of coarse delay cell circuits that are enabled; and
   - adjusting a fine delay cell circuit until the delay imparted on the input signal by the fine delay cell circuit is equal to the difference between the target delay and the coarse delay that is imparted by the enabled coarse delay cell circuits, wherein the output of the fine delay cell circuit is the output signal.

2. The method of claim 1, wherein incrementally changing the number of coarse delay cell circuits that are enabled comprises determining a phase difference between the input signal and the output signal to generate a phase differential signal and updating a counter value in response to the phase differential signal.

3. The method of claim 2, wherein determining the phase difference comprises comparing the phase difference between the input signal and the output signal with a target phase difference to generate the phase differential signal, wherein the target phase difference corresponds to the target delay.

4. The method of claim 2, wherein the coarse delay cell circuits are enabled according to the counter value.

5. The method of claim 2, wherein the fine delay cell circuit is adjusted according to the phase differential signal.

6. The method of claim 5, wherein the input signal is delayed by the fine delay cell circuit a time interval that is proportional to the phase differential signal.

7. The method of claim 2, wherein incrementally changing the number of coarse delay cell circuits that are enabled further comprises sampling the phase differential signal on a rising edge of a sampling clock to generate a sampling result and updating the counter value in response to the sampling result.

8. The method of claim 1, wherein the number of coarse delay cell circuits that are enabled is incrementally decreased or incrementally increased.

9. A digital phase shifter for imparting a target delay on an input signal to generate an output signal, the digital phase shifter comprising:

- a plurality of serially connected coarse delay cell circuits, wherein each coarse delay cell circuit is configured to impart a fixed period of delay on the input signal, and wherein the coarse delay imparted by the serially connected coarse delay cell circuits is a function of the number of coarse delay cell circuits that are enabled;
- a fine delay cell circuit configured to impart a delay on the input signal to generate the output signal, wherein the delay is smaller than the fixed period of delay that is imparted by a single coarse delay cell circuit; and
- a delay adjuster configured to incrementally change the number of coarse delay cell circuits that are enabled until the difference between the target delay and the coarse delay is smaller than the fixed period of delay that is imparted by a single coarse delay cell circuit and to adjust the fine delay cell circuit until the delay imparted by the fine delay cell circuit is equal to the difference between the target delay and the coarse delay that is imparted by the enabled coarse delay cell circuits.

10. The digital phase shifter of claim 9, wherein the delay adjuster is further configured to determine a phase difference between the input signal and the output signal to generate a phase differential signal and to update a counter value in response to the phase differential signal.

11. The digital phase shifter of claim 10, wherein the delay adjuster is further configured to compare the phase difference between the input signal and the output signal with a target phase difference to generate the phase differential signal, wherein the target phase difference corresponds to the target delay.

12. The digital phase shifter of claim 10, wherein the delay adjuster is further configured to enable the coarse delay cell circuits according to the counter value.

13. The digital phase shifter of claim 10, wherein the delay adjuster is further configured to adjust the fine delay cell circuit according to the phase differential signal.

14. The digital phase shifter of claim 13, wherein the fine delay cell circuit is further configured to delay the input signal a time interval that is proportional to the phase differential signal.

15. The digital phase shifter of claim 10, wherein the delay adjuster is further configured to sample the phase differential signal on a rising edge of a sampling clock to generate a sampling result and to update the counter value in response to the sampling result.

16. The digital phase shifter of claim 9, wherein the delay adjuster is further configured to incrementally decrease or incrementally increase the number of coarse delay cell circuits that are enabled.

**17.** A digital phase shifting method for imparting a target delay on an input signal to generate an output signal, the digital phase shifting method comprising:

- operating in a calibration mode, wherein operating in the calibration mode includes determining a phase difference between the input signal and the output signal to generate a phase differential signal, updating a counter value in response to the phase differential signal, and incrementally changing the number of coarse delay cell circuits that are enabled in response to the counter value until the difference between the target delay and the coarse delay that is imparted by the enabled coarse delay cell circuits is smaller than a fixed period of delay that is imparted by a single coarse delay cell circuit, wherein the coarse delay that is imparted by the enabled coarse delay cell circuits is a function of the number of coarse delay cell circuits that are enabled; and
- once the difference between the target delay and the coarse delay that is imparted by the enabled coarse delay cell circuits is smaller than a fixed period of delay that is imparted by a single coarse delay cell circuit, operating in a continuous operation mode, wherein operating in the continuous operation mode includes adjusting a fine delay cell circuit according to the phase differential signal until the delay imparted by the fine delay cell circuit on the input signal is equal to the difference between the target delay and the coarse delay that is imparted by the enabled coarse delay cell circuits, wherein the output of the fine delay cell circuit is the output signal.

**18.** The method of claim 17, wherein determining the phase difference comprises comparing the phase difference between the input signal and the output signal with a target phase difference to generate the phase differential signal, wherein the target phase difference corresponds to the target delay.

**19.** The method of claim 17, wherein the number of coarse delay cell circuits that are enabled is incrementally decreased or incrementally increased.

**20.** The method of claim 17, wherein incrementally changing the number of coarse delay cell circuits that are enabled further comprises sampling the phase differential signal on a rising edge of a sampling clock to generate a sampling result and updating the counter value in response to the sampling result.

FIG. 1

FIG. 2

FIG. 3

FIG. 4

EP 2 242 178 A1

COUNTER VALUE
OF THE DELAY
ADJUSTER

FDCC

500

R-2R NETWORK — 502

504

Sout

MIXED
GAIN CELL

FIG. 5

INCREMENTALLY CHANGE THE NUMBER OF COARSE DELAY CELL CIRCUITS THAT ARE ENABLED UNTIL THE DIFFERENCE BETWEEN THE TARGET DELAY AND THE COARSE DELAY THAT IS IMPARTED BY THE ENABLED COARSE DELAY CELL CIRCUITS IS SMALLER THAN A FIXED PERIOD OF DELAY THAT IS IMPARTED BY A SINGLE COARSE DELAY CELL CIRCUIT, WHERE THE COARSE DELAY THAT IS IMPARTED BY THE ENABLED COARSE DELAY CELL CIRCUITS IS A FUNCTION OF THE NUMBER OF COARSE DELAY CELL CIRCUITS THAT ARE ENABLED

602

ADJUST A FINE DELAY CELL CIRCUIT UNTIL THE DELAY IMPARTED ON THE INPUT SIGNAL BY THE FINE DELAY CELL CIRCUIT IS EQUAL TO THE DIFFERENCE BETWEEN THE TARGET DELAY AND THE COARSE DELAY THAT IS IMPARTED BY THE ENABLED COARSE DELAY CELL CIRCUITS, WHERE THE OUTPUT OF THE FINE DELAY CELL CIRCUIT IS THE OUTPUT SIGNAL

604

FIG. 6

**EUROPEAN SEARCH REPORT**

Application Number

EP 09 29 0277

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/125905 A1 (VLASENKO PETER [CA] ET AL) 1 July 2004 (2004-07-01) * paragraphs [0025] - [0035], [0039] - [0046]; figures 3,4A * ----- | 1-20 | INV. H03K5/13 |
| X | US 6 194 928 B1 (HEYNE PATRICK [DE]) 27 February 2001 (2001-02-27) * column 3, line 41 - column 6, line 10; figures 1-3 * ----- | 1-20 | |

**TECHNICAL FIELDS SEARCHED (IPC)**

H03K

The present search report has been drawn up for all claims

| Place of search | Date of completion of the search | Examiner |
|---|---|---|
| Munich | 28 October 2009 | Moll, Peter |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

...................................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 09 29 0277

This annex lists the patent family members relating to the patent documents cited in the above-mentioned European search report.
The members are as contained in the European Patent Office EDP file on
The European Patent Office is in no way liable for these particulars which are merely given for the purpose of information.

28-10-2009

| Patent document cited in search report | | Publication date | Patent family member(s) | | Publication date |
|---|---|---|---|---|---|
| US 2004125905 | A1 | 01-07-2004 | AU 2003294604 A1 | | 22-07-2004 |
| | | | WO 2004059846 A1 | | 15-07-2004 |
| | | | CN 1732623 A | | 08-02-2006 |
| | | | EP 1588489 A1 | | 26-10-2005 |
| | | | KR 20050091038 A | | 14-09-2005 |
| | | | US 2008089459 A1 | | 17-04-2008 |
| US 6194928 | B1 | 27-02-2001 | DE 19845115 A1 | | 13-04-2000 |

EPO FORM P0459

For more details about this annex : see Official Journal of the European Patent Office, No. 12/82